# EUROPEAN PATENT APPLICATION

(11) **EP 0 935 290 A2**
(43) Date of publication of application: **11.08.1999**
(21) Application number: 99101852.4
(22) Date of filing: 28.01.1999
(51) Int. Cl.: H01L 27/06, H01L 27/088, F02P 3/04

(54) **Power semiconductor device and method**

(30) Priority: 09.02.1998 US 20815
(71) Applicant: MOTOROLA, INC., Schaumburg, IL 60196 (US)
(72) Inventor: Meyer, Robert Anton, 81245 Munich (DE); Kraus, Robert, 80801 Munich (DE); Eshaghi, Majid, Phoenix, Arizona 85045 (US)
(74) Representative: Gibson, Sarah Jane

(57) **Abstract**

A power semiconductor device (10) and a method for increasing the turn-on time and the turn-off time of the power semiconductor device (10). The power semiconductor device (10) has a first stage (14) and a second stage (16), wherein a transconductance of the first stage (14) is less than a transconductance of the second stage (16). The turn-on time of the power semiconductor device (10) is increased by turning on the first stage (14) before turning on the second stage (16). In addition, the turn-off time of the power semiconductor device (10) is increased by turning off the first stage (14) before turning off the second stage (16).

## Description

### Background of the Invention

The present invention relates, in general, to semiconductor devices and, more particularly, to power semiconductor devices.

Typical ignition systems include power semiconductor devices such as power Metal Oxide Semiconductor Field Effect Transistors (MOSFETs) to generate high voltages at the spark plug of the ignition system. In general, the power MOSFET is coupled to the spark plug via a transformer. The drain of the power MOSFET is connected to the primary coil of the transformer and the secondary coil of the transformer is connected to the spark plug. In addition, the primary coil is coupled for receiving a supply voltage or a battery voltage.

When the power MOSFET is on, the voltage at the secondary coil is a predicted value approximately equal to the product of the battery voltage and the turns ratio of the transformer. When the power MOSFET is switched on and then switched off, the energy stored in the transformer causes the drain voltage of the power MOSFET to rise substantially higher than the battery voltage. This creates an increase in the voltage at the primary coil of the transformer that results in an increase in the voltage at the secondary coil of the transformer. A spark is produced by the spark plug

when the voltage at the secondary coil increases to a level higher than a threshold voltage of the spark plug.

Some engine control systems such as a traction control system preferably include an ignition system which allows turn off of the power MOSFET without creating a spark. This allows for a reduction of engine torque. A disadvantage of a typical ignition system is that, when the power MOSFET is switched on, it can not be switched off without creating a spark, resulting in engine torque which might be undesirable when the traction control system needs to cut engine torque.

A potential problem known as "spark-on-make" can occur when the power MOSFET is initially turned on. "Spark-on-make" is caused by the voltage at the drain of the power MOSFET resonating because of the leakage inductance of the transformer, the parasitic capacitance of the transformer, and the parasitic capacitance of the spark plug. The resonant voltage produces a voltage at the secondary coil that exceeds the threshold voltage of the spark plug. Resonance produces a ringing effect or oscillation that causes the voltage at the secondary coil to exceed or overshoot the predicted value. This overshoot voltage can generate an undesirable spark when the power MOSFET is initially turned on.

One technique for preventing "spark-on-make" in an ignition system is to add a blocking diode in series with the spark plug. Problems with this technique include the cost of the blocking diode, the reliability of the blocking diode, and the added space for the blocking diode. Another technique used to prevent "spark-on-make" is to reduce the turns ratio of the transformer. A disadvantage of this technique is that a higher voltage at the primary coil is needed to generate the threshold voltage of the spark plug at the secondary coil. Typically, a higher voltage power semiconductor device requiring more die area is used to generate the higher voltage at the primary coil.

Accordingly, it would be advantageous to have a power semiconductor device and a method for preventing "spark-on-make." It would be of further advantage to have a method for preventing sparks for traction control systems and for the power semiconductor device to be cost efficient and reliable.

### Brief Description of the Drawings

FIG. 1 is a schematic diagram of a power semiconductor device in accordance with a first embodiment of the present invention;
FIG. 2 is a schematic diagram of a power semiconductor device in accordance with a second embodiment of the present invention; and
FIG. 3 is a schematic diagram of a power semiconductor device in accordance with a third embodiment of the present invention.

### Detailed Description of the Drawings

Generally, the present invention provides a power semiconductor device and a method for altering the turn-on and turn-off times of the power semiconductor device. More particularly, the present invention provides a power semiconductor device having at least two stages for increasing the turn-on and the turn-off times of the power semiconductor device. The turn-on time of a power semiconductor device in accordance with the present invention is increased compared to a typical single stage power semiconductor device. Similarly, the turn-off time of a power semiconductor device of the present invention can be increased relative to a typical power semiconductor device. In systems where the power semiconductor device is coupled to a spark plug via an inductive load such as a transformer, the semiconductor device of the present invention limits the change in voltage with respect to time (dv/dt) at the primary coil of the transformer when the power semiconductor device is initially turned on. This reduces undesirable overshoot voltage and oscillation at the secondary coil of the transformer. Limiting the dv/dt at the primary coil is accomplished by increasing the turn-on time of the power semiconductor device. In addition, the semiconductor device of the present invention has the ability to alter the dv/dt at the primary coil when the power semiconductor device is switched off by increasing the turn-off time of the semiconductor power device. This allows the ignition system to choose whether a spark will be generated or not generated when the power semiconductor device is switched off after it is switched on.

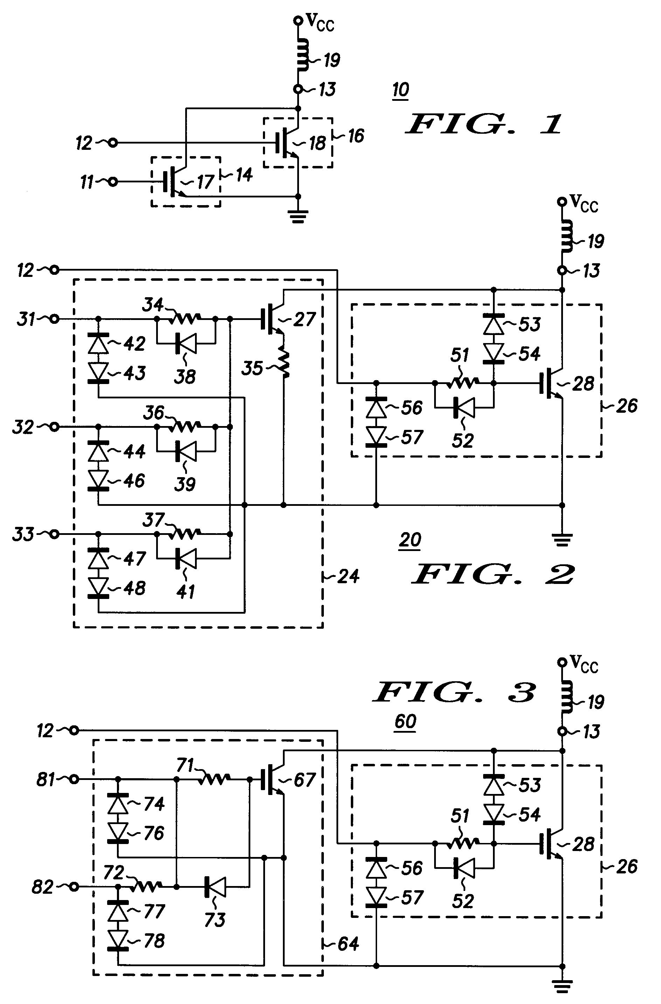

FIG. 1 is a schematic diagram of a power semiconductor device 10 in accordance with a first embodiment of the present invention. Power semiconductor device 10 has input terminals 11 and 12 and an output terminal 13. Further, power semiconductor device 10 has a first stage 14 and a second stage 16. By way of example, first stage 14 is comprised of a transistor 17 and second stage 16 is comprised of a transistor 18. Preferably, the transconductance of transistor 17 is less than the transconductance of transistor 18. Transistor 17 is also referred to as a pilot transistor and transistor 18 is also referred to as a main transistor. Transistors 17 and 18 are Insulated Gate Bipolar Transistors (IGBTs), wherein each transistor has a gate, a collector, and an emitter. Input terminal 11 is connected to the gate of IGBT 17 and input terminal 12 is connected to the gate of IGBT 18. Preferably, the collectors of IGBTs 17 and 18 are connected to output terminal 13 and the emitters of IGBTs 17 and 18 are coupled for receiving a power supply voltage such as, for example, ground. Alternatively, the emitter of IGBT 17 can be connected to the emitter of IGBT 18 and the emitter of IGBT 18 or IGBT 17 can be coupled for receiving a power supply voltage such as, for example, ground. Although transistors 17 and 18 are described as IGBTs, this is not a limitation of the present invention. Transistors 17 and 18 can be Metal Oxide Semiconductor Field Effect Transistors (MOSFETs), bipolar transistors, thyristors, or the like. It should be noted that the gate of a Field Effect Transistor (FET) is referred to as a control electrode and the drain and the source of a FET are referred to as current carrying electrodes. Likewise, the base of a bipolar transistor is referred to as a control electrode and the collector and the emitter of a bipolar transistor are referred to as current carrying electrodes. Similarly, the gate of an IGBT is referred to as a control electrode and the collector and the emitter of an IGBT are referred to as current carrying electrodes.

FIG. 1 further illustrates power semiconductor device 10 connected to an inductive load 19. The first terminal of inductive load 19 is connected to output terminal 13 and the second terminal of inductive load 19 is coupled for receiving a power supply voltage such as, for example, voltage Vcc.

In operation, input terminal 11 is coupled for receiving a pilot control signal and input terminal 12 is coupled for receiving a main control signal. First stage 14 and second stage 16 cooperate to switch the voltage across inductive load 19. The voltage at output terminal 13 can be switched between approximately ground and a value substantially greater than the voltage Vcc. When the voltage of the pilot control signal is less than the threshold voltage of IGBT 17 and the voltage of the main control signal is less than the threshold voltage of IGBT 18, IGBTs 17 and 18 are off and the voltage at output terminal 13 is approximately equal to the voltage Vcc. When the voltage of the pilot control signal is increased to a voltage greater than the threshold voltage of IGBT 17 and the voltage of the main control signal is increased to a voltage greater than the threshold voltage of IGBT 18, IGBTs 17 and 18 turn on. When IGBTs 17 and 18 turn on, the voltage at output terminal 13 falls from approximately the voltage Vcc to the voltage drop between the collector and the emitter of IGBT 18, i.e., Vceon. The time it takes for the voltage at output terminal 13 to change from approximately the voltage Vcc to the voltage Vceon is referred to as the fall time of the voltage at output terminal 13 or the turn-on time of power semiconductor device 10.

The pilot control signal and the main control signal can be used to separately turn on and turn off IGBTs 17 and 18. Since the transconductance of IGBT 17 is less than the transconductance of IGBT 18, turning on IGBT 17 before IGBT 18 causes the voltage at output terminal 13 to fall at a slower rate compared to a power semiconductor device comprising only a single IGBT. In other words, the fall time of the voltage at output terminal 13 is increased by IGBT 17 turning on before IGBT 18 because IGBT 17 discharges the output capacitance of IGBT 18 and the parasitic capacitance of inductive load 19. Therefore, turning on IGBT 17 before turning on IGBT 18 increases the turn-on time of power semiconductor device 10.

When the voltage of the pilot control signal is decreased to a voltage below the threshold voltage of IGBT 17 and the main control signal is decreased to a voltage below the threshold voltage of IGBT 18, IGBTs 17 and 18 turn off. The energy stored in inductive load 19 causes the voltage at output terminal 13 to rise above the voltage Vcc. The voltage at output terminal 13 rises to a level equal to the collector-emitter avalanche voltage of IGBT 17 and IGBT 18, and the energy stored in inductive load 19 is discharged via IGBT 17 and IGBT 18. The maximum voltage level appearing at output terminal 13 can be reduced by increasing the turn-off time of power semiconductor device 10. Since the transconductance of IGBT 17 is less than the transconductance of IGBT 18, the turn-off time of power semiconductor device 10 will depend on when IGBT 17 is turned off relative to when IGBT 18 is turned off. For example, power semiconductor device 10 turns off slower when IGBT 17 is turned off before IGBT 18 compared to when IGBTs 17 and 18 are turned off at the same time. In other words, turning off IGBT 17 before IGBT 18 increases the turn-off time of power semiconductor device 10 relative to the turn-off time of power semiconductor device 10 when IGBTs 17 and 18 are turned off at the same time. In addition, power semiconductor device 10 has a slower turn-off time compared to a power semiconductor device comprising only a single IGBT.

Although power semiconductor device 10 is illustrated as having two stages, this is not a limitation of the present invention. Power semiconductor device 10 can have two or more stages wherein each preceding stage includes a transistor having a lower transconductance than the transconductance of the transistor of second stage 16, i.e., the last stage.

FIG. 2 is a schematic diagram of a power semiconductor device 20 in accordance with a second embodiment of the present invention. It should be understood that the same reference numerals are used in the figures to denote the same elements. Power semiconductor device 20 includes a first stage 24 and a second stage 26. Power semiconductor device 20 is similar to power semiconductor device 10 (FIG. 1) in that the turn-on time of power semiconductor device 20 is increased by turning on first stage 24 before turning on second stage 26. In addition, the turn-off time of power semiconductor device 20 can be increased by turning off first stage 24 before turning off second stage 26.

First stage 24 is comprised of a transistor 27, resistors 34, 35, 36, and 37, and diodes 38, 39, 41, 42, 43, 44, 46, 47, and 48. Second stage 26 is comprised of a transistor 28, a resistor 51, and diodes 52, 53, 54, 56, and 57. By way of example, transistors 27 and 28 are IGBTs, wherein the transconductance of IGBT 27 is less than the transconductance of IGBT 28.

First stage 24 has three input terminals 31, 32, and 33 coupled for receiving a pilot control signal. Input terminal 31 is commonly connected to the first terminal of resistor 34, the cathode of diode 38, and the cathode of diode 42. The anode of diode 42 is connected to the anode of diode 43 and the cathode of diode 43 is coupled for receiving a power supply voltage such as, for example, ground. Input terminal 32 is commonly connected to the first terminal of resistor 36, the cathode of diode 39, and the cathode of diode 44. The anode of diode 44 is connected to the anode of diode 46 and the cathode of diode 46 is coupled for receiving a power supply voltage such as, for example, ground. Input terminal 33 is commonly connected to the first terminal of resistor 37, the cathode of diode 41, and the cathode of diode 47. The anode of diode 47 is connected to the anode of diode 48 and the cathode of diode 48 is coupled for receiving a power supply voltage such as, for example, ground. The gate of IGBT 27 is commonly connected to the second terminals of resistors 34, 36, and 37 and to the anodes of diodes 38, 39, and 41. The collector of IGBT 27 is connected to output terminal 13. The emitter of IGBT 27 is connected to the first terminal of resistor 35 and the second terminal of resistor 35 is coupled for receiving a power supply voltage such as, for example, ground.

Input terminal 12 is commonly connected to the first terminal of resistor 51, the cathode of diode 52, and the cathode of diode 56. The anode of diode 56 is connected to the anode of diode 57 and the cathode of diode 57 is coupled for receiving a power supply voltage such as, for example, ground. The gate of IGBT 28 is commonly connected to the second terminal of resistor 51, the anode of diode 52, and the cathode of diode 54. Accordingly, resistor 51 is in parallel with diode 52. The anode of diode 54 is connected to the anode of diode 53 and the cathode of diode 53 is connected to output terminal 13. The collector of IGBT 28 is connected to output terminal 13 and the emitter of IGBT 28 is coupled for receiving a power supply voltage such as, for example, ground.

The operation of power semiconductor device 20 is similar to the operation of power semiconductor device 10 (FIG. 1) except that first stage 24 has three input terminals for receiving a pilot control signal. The pilot control signal is received at either input terminal 31, input terminal 32, or input terminal 33 for turning IGBT 27 on or off. Input terminal 12 is coupled for receiving a main control signal for turning IGBT 28 on or off. Turning on IGBT 27 before turning on IGBT 28 increases the turn-on time of power semiconductor device 20. Similarly, turning off IGBT 27 before turning off IGBT 28 increases the turn-off time of power semiconductor device 20.

Resistors 34, 36, and 37 of first stage 24 increase the turn-on time of power semiconductor device 20 by increasing the turn-on time of IGBT 27. Preferably, the resistance of resistor 37 is greater than the resistance of resistor 36 and the resistance of resistor 36 is greater than the resistance of resistor 34. Therefore, IGBT 27 has a long turn-on time when it is turned on via input terminal 33 compared to when it is turned on via input terminal 32. Likewise, IGBT 27 has a longer turn-on time when it is turned on via input terminal 32 compared to when it is turned on via input terminal 31. Preferably, the on resistances of diodes 38, 39, and 41 is less than the resistances of resistors 34, 36, and 37, respectively. Diodes 38, 39, and 41 reduce the turn-off time of IGBT 27. Diodes 42 and 43 provide protection from large overvoltages appearing at input terminal 31. Similarly, diodes 44 and 46 and diodes 47 and 48 provide protection from large overvoltages appearing at input terminals 32 and 33, respectively. Resistor 35 further lowers the transconductance of IGBT 27.

Resistor 51 of second stage 26 increases the turn-on time of IGBT 28 whereas diode 52 reduces the turn-off time of IGBT 28. Diodes 56 and 57 provide protection from large overvoltages appearing at input terminal 12. Diodes 53 and 54 clamp the voltage at output terminal 13 and therefore are also referred to as clamp diodes. The voltage at which output terminal 13 is clamped is approximately equal to the sum of the reverse breakdown voltage of diode 53 and the forward voltage drop across diode 54. Preferably, diodes 53 and 54 are chosen so that the reverse breakdown voltage of diode 53 and the forward voltage drop across diode 54 are less than the avalanche voltage of IGBT 28. Therefore, when IGBTs 27 and 28 are turned on and then turned off, the energy stored in inductive load 19 causes output terminal 13 to rise to a voltage approximately equal to the clamp voltage at output terminal 13.

FIG. 3 is a schematic diagram of a power semiconductor device 60 in accordance with a third embodiment of the present invention. Power semiconductor device 60 includes a first stage 64 connected to second stage 26. Power semiconductor device 60 is similar to power semiconductor device 20 (FIG. 2) in that the turn-on time of power semiconductor device 60 is increased by turning on first stage 64 before turning on second stage 26. In addition, the turn-off time of power semiconductor device 60 is increased by turning off first stage 64 before turning off second stage 26.

First stage 64 is comprised of a transistor 67, resistors 71 and 72, and diodes 73, 74, 76, 77, and 78. By way of example, transistors 67 is an IGBT, wherein the transconductance of IGBT 67 is less than the transconductance of IGBT 28.

First stage 64 has two input terminals 81 and 82 for receiving a pilot control signal. Input terminal 81 is commonly connected to the first terminal of resistor 71, the cathode of diode 73, and the cathode of diode 74. The anode of diode 74 is connected to the anode of diode 76 and the cathode of diode 76 is coupled for receiving a power supply voltage such as, for example, ground. The gate of IGBT 67 is commonly connected to the second terminal of resistor 71 and the anode of diode 73. The collector of IGBT 67 is connected to output terminal 13, and the emitter of IGBT 67 is coupled for receiving a power supply voltage such as, for example, ground. Input terminal 82 is commonly connected to the first terminal of resistor 72 and the cathode of diode 77. The second terminal of resistor 72 is commonly connected to the cathode of diode 73 and the first terminal of resistor 71. The anode of diode 77 is connected to the anode of diode 78, and the cathode of diode 78 is coupled for receiving a power supply voltage such as, for example, ground.

The operation of power semiconductor device 60 is similar to the operation of power semiconductor device 20 (FIG. 2) except that first stage 64 has two input terminals for receiving a pilot control signal. The pilot control signal is received at either input terminal 81 or input terminal 82 for turning IGBT 67 on or off. As described with reference to FIG. 2, input terminal 12 is coupled for receiving a main control signal for turning IGBT 28 on or off. Power semiconductor device 60 has a longer turn-on time when IGBT 67 is turned on before IGBT 28 compared to when IGBTs 67 and 28 are turned on at the same time. Similarly, power semiconductor device 60 has a longer turn-off time when IGBT 67 is turned off before IGBT 28 compared to when IGBTs 67 and 28 are turned off at the same time.

Resistors 71 and 72 of first stage 64 increase the turn-on time of IGBT 67. Since the resistance between input terminal 82 and the gate of IGBT 67 is greater than the resistance between input terminal 81 and the gate of IGBT 67, the turn-on time of IGBT 67 is longer when IGBT 67 is turned on via input terminal 82 compared to when IGBT 67 is turned on via input terminal 81. Diode 73 is used to reduce the turn-off time of IGBT 67. IGBT 67 is turned off either by input terminal 81 or input terminal 82. Therefore, the turn-off time of IGBT 67 is increased when IGBT 67 is turned off via input terminal 82 compared to when IGBT 67 is turned off via input terminal 81. Diodes 74 and 76 and diodes 77 and 78 provide protection from large overvoltages appearing at input terminals 81 and 82, respectively.

By now it should be appreciated that a power semiconductor device and a method for altering the turn-on time and the turn-off time of the power semiconductor device have been provided. An advantage of the present invention is that it can be used in ignition systems to reduce the overshoot voltage at the secondary coil of the transformer, thereby preventing problems such as "spark-on-make." Further, the present invention can be used to prevent sparks in traction control systems. Another advantage of the present invention is that it can be manufactured using standard semiconductor processing techniques.

## Claims

1. A power semiconductor device (20), characterised by:
a first transistor (28) having a control electrode, a first current carrying electrode, a second current carrying electrode coupled for receiving a power supply voltage, and a transconductance; and
a second transistor (27) having a control electrode, a first current carrying electrode coupled to the first current carrying electrode of the first transistor, a second current carrying electrode coupled for receiving the power supply voltage, and a transconductance less than the transconductance of the first transistor (27).

2. The power semiconductor device of claim 1, further characterised by:
a first resistor (34) having a first terminal and a second terminal, wherein the second terminal is coupled to the control electrode of the second transistor (27); and
a second resistor (36) having a first terminal and a second terminal, wherein the second terminal is coupled to the control electrode of the second transistor (27).

3. The power semiconductor device of claim 2, further characterised by:
a first diode (38) having an anode coupled to the second terminal of the first resistor (34) and a cathode coupled to the first terminal of the first resistor (34); and
a second diode (39) having an anode coupled to the second terminal of the second resistor (36) and a cathode coupled to the first terminal of the second resistor (36).

4. The power semiconductor device of claim 3, further characterised by:
a first diode (42) having a cathode coupled to the first terminal of the first resistor (34) and an anode;
a second diode (43) having an anode coupled to the anode of the first diode (42) and a cathode coupled for receiving the power supply voltage;
a third diode (44) having a cathode coupled to the first terminal of the second resistor (36) and an anode; and
a fourth diode (46) having an anode coupled to the anode of the third diode and a cathode coupled for receiving the power supply voltage.

5. A power semiconductor device (60), characterised by:
a first transistor (28) having a control electrode, a first current carrying electrode, and a second current carrying electrode coupled for receiving a power supply voltage;
a second transistor (67) having a control electrode, a first current carrying electrode coupled to the first current carrying electrode of the first transistor (28), and a second current carrying electrode coupled for receiving the power supply voltage;
a first diode (73) having an anode coupled to the control electrode of the second transistor (67) and a cathode;
a first resistor (71) having a first terminal coupled to the cathode of the first diode (73) and a second terminal coupled to the control electrode of the second transistor (67); and
a second resistor (72) having a first terminal and a second terminal coupled to the cathode of the first diode (73).

6. The power semiconductor device of claim 5, wherein a transconductance of the second transistor (67) is less than a transconductance of the first transistor (28).

7. The power semiconductor device of claim 5, further characterised by a third resistor (51) having a first terminal and a second terminal coupled to the control electrode of the first transistor (28).

8. The power semiconductor device of claim 7, further characterised by a second diode (52) having an anode coupled to the second terminal of the third resistor (51) and a cathode coupled to the first terminal of the third resistor (51).

9. A method for altering a turn-on time of a power semiconductor device (20) and a turn-off time of the power semiconductor device (20), characterised by the steps of:
providing the power semiconductor device (20) having a first stage (24) and a second stage (26);
increasing the turn-on time of the power semiconductor device by turning on the first stage (24) of the power semiconductor device (20) before turning on the second stage (26) of the power semiconductor device (20); and
increasing the turn-off time of the power semiconductor (20) device by turning off the first stage (24) of the power semiconductor device before turning off the second stage (26) of the power semiconductor device (20).

10. The method of claim 9, wherein the step of providing a semiconductor device (20) having a first stage (24) and a second stage (26) includes providing a first stage (24) having a transconductance that is less than a transconductance of the second stage (26).
